# EUROPEAN PATENT APPLICATION

(11) **EP 3 429 170 A1**
(43) Date of publication of application: **16.01.2019**
(21) Application number: 16895858.5
(22) Date of filing: 29.03.2016
(51) Int. Cl.: H04M 1/02, H05K 5/06

(54) **MOBILE TERMINAL PORT AND MOBILE TERMINAL**

(71) Applicant: Huawei Technologies Co., Ltd., Longgang District Shenzhen, Guangdong 518129 (CN)
(72) Inventor: WANG, Gaofeng, Shenzhen Guangdong 518129 (CN); ZHU, Haifeng, Shenzhen Guangdong 518129 (CN); SHI, Feng, Shenzhen Guangdong 518129 (CN); LI, Guanglong, Shenzhen Guangdong 518129 (CN)
(74) Representative: Gill Jennings & Every LLP
(86) International application number: PCT/CN2016/077736
(87) International publication number: WO 2017/166077

(57) **Abstract**

The present invention provides a mobile terminal port. The terminal port includes a port body and a sealing cover. The sealing cover is assembled surrounding an opening end of the port body, the sealing cover has an elastic extrusion part that extends outside the opening end, and the elastic extrusion part is extruded and deformed along a vertical direction of the port body. In the foregoing technical solutions, the sealing cover is directly assembled surrounding the port body. The sealing cover extends outside an end face of the port body in a parallel manner, and may form waterproof sealing with a housing of a waterproof mobile terminal device. However, an existing sealing silicone ring extends in a normal direction of a metal sleeve, and a housing needs to be made to match a shape of the sleeve and then can be sealed. In comparison with the prior art, a parallel design is used in a sealing structure provided in the embodiments of the present invention, and the housing can be assembled and sealed by using only a small plane. This greatly reduces a length of the mobile device and reduces an assembling difficulty. In addition, a vertical extrusion manner effectively improves a sealing effect.

## Description

### TECHNICAL FIELD

The present invention relates to the field of communications technologies, and in particular, to a mobile terminal port and a mobile terminal.

### BACKGROUND

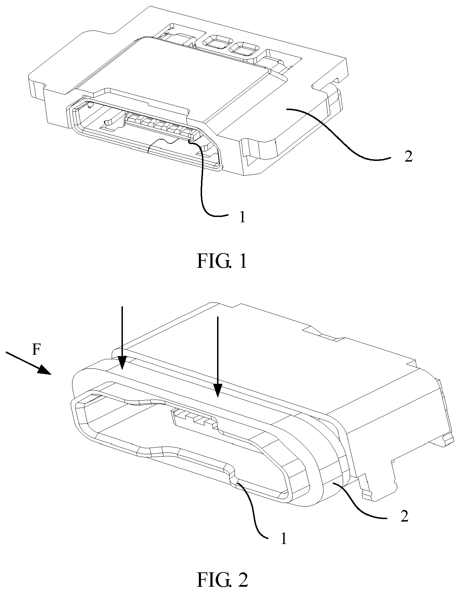

In an existing waterproof design of a mobile phone, a device + silicone cover dual-device assembly manner is used, and liquid injection silicone is used and molded on a plastic or iron surface. An all-in-one waterproof design solution can effectively improve waterproof reliability of the entire mobile phone. As shown in FIG. 1 and FIG. 2, FIG. 1 and FIG. 2 show schematic diagrams of mobile terminal ports in different shapes. A terminal port 1 and a silicone cover 2 that is assembled surrounding the terminal port 1 are included. In a process of sealing, as shown in FIG. 2, a force F perpendicular to a surface of the silicone cover 2 is applied to the silicone cover 2, and the silicone cover 2 is extruded and deformed horizontally, to form waterproof sealing. However, when a mobile terminal using the foregoing sealing structure is produced, in a manner of assembling a silicone cover in a production line, a defect case in which the silicone cover is not assembled in place occurs easily. Consequently, a waterproof effect of the entire mobile terminal becomes poor.

### SUMMARY

The present invention provides a mobile terminal port and a mobile terminal, to improve a sealing effect of the mobile terminal.

The present invention provides a mobile terminal port, where the terminal port includes a port body and a sealing cover, the sealing cover is assembled surrounding an opening end of the port body, the sealing cover has an elastic extrusion part that extends outside the opening end, and the elastic extrusion part is extruded and deformed along a vertical direction of the port body.

In the foregoing embodiment, the sealing cover is directly assembled surrounding the port body. The sealing cover extends outside an end face of the port body in a parallel manner, and may form waterproof sealing with a housing of a waterproof mobile terminal device. However, an existing sealing silicone ring extends in a normal direction of a metal sleeve, and the housing needs to be made to match a shape of the sleeve and then can be sealed. In comparison with the prior art, a parallel design is used in a sealing structure provided in this embodiment of the present invention, and the housing can be assembled and sealed by using only a small plane. This greatly reduces a length of the mobile device and reduces an assembling difficulty. In addition, a vertical extrusion manner effectively improves a sealing effect.

In a specific implementation, a card slot is disposed around a side wall of the port body, and the sealing cover is clamped in the card slot. The card slot is disposed on the port body, and the sealing cover is clamped in the card slot, so as to provide a support force to the sealing cover.

During specific disposal, an end face, which is far away from the opening end, of the elastic extrusion part is an inclined surface matching a housing of a mobile terminal. The elastic extrusion part may form a matching structure according to a shape of the housing, so as to ensure sealing of the port.

To further improve sealing of the terminal port, a ring-shaped protrusion structure is disposed on the end face, which is far away from the opening end, of the elastic extrusion part. The protrusion structure matches the housing. Therefore, the sealing effect is further improved.

Preferably, to ensure the sealing effect, the sealing cover is injected and molded on the port body. The sealing cover is directly injected and molded on the port body. Therefore, sealing between the sealing cover and the port body is ensured.

The present invention further provides a mobile terminal, where the mobile terminal includes a housing and the foregoing mobile terminal port.

An opening structure is disposed on the housing, the mobile terminal port is located inside the housing, and an elastic sealing cover of the mobile terminal port is connected to the opening structure in a sealing manner.

In the foregoing embodiment, the sealing cover is directly assembled surrounding a port body. The sealing cover extends outside an end face of the port body in a parallel manner, and may form waterproof sealing with the housing of the waterproof mobile terminal device. However, an existing sealing silicone ring extends in a normal direction of a metal sleeve, and the housing needs to be made to match a shape of the sleeve and then can be sealed. In comparison with the prior art, a parallel design is used in a sealing structure provided in this embodiment of the present invention, and the housing can be assembled and sealed by using only a small plane. This greatly reduces a length of the mobile device and reduces an assembling difficulty. In addition, a vertical extrusion manner effectively improves a sealing effect.

During specific disposal, when a ring-shaped protrusion structure is disposed on an end face, which is far away from the opening end, of the elastic extrusion part, a groove matching the protrusion structure is disposed on a side wall inside the housing and around the opening structure. The groove matches the protrusion structure. Therefore, assembly accuracy is further improved, and the sealing effect is improved.

In a specific embodiment, a cross section of the groove is arc-shaped, and the protrusion structure has an arc-shaped end face matching the groove. Matching of the arc-shaped groove further improves the sealing effect.

### BRIEF DESCRIPTION OF DRAWINGS

FIG. 1 is a schematic structural diagram of a mobile terminal port in the prior art;
FIG. 2 is a schematic structural diagram of another mobile terminal port in the prior art;
FIG. 3 is a schematic structural diagram of a mobile terminal port according to an embodiment of the present invention;
FIG. 4 is a schematic structural diagram of another mobile terminal port according to an embodiment of the present invention;
FIG. 5 is a sectional view of another mobile terminal port according to an embodiment of the present invention; and
FIG. 6 is a use status reference diagram of a mobile terminal port according to an embodiment of the present invention.

### Reference signs:

1. Terminal port; 2. Silicone cover; 10. Port body
   11. Card slot; 20. Sealing cover; 21. Elastic extrusion part
   22. Protrusion structure; 23. Inclined surface; 30. Housing

### DESCRIPTION OF EMBODIMENTS

To make the objectives, technical solutions, and advantages of the present invention clearer, the following further describes the present invention in detail with reference to the accompanying drawings. Apparently, the described embodiments are merely some but not all of the embodiments of the present invention. All other embodiments obtained by a person of ordinary skill in the art based on the embodiments of the present invention without creative efforts shall fall within the protection scope of the present invention.

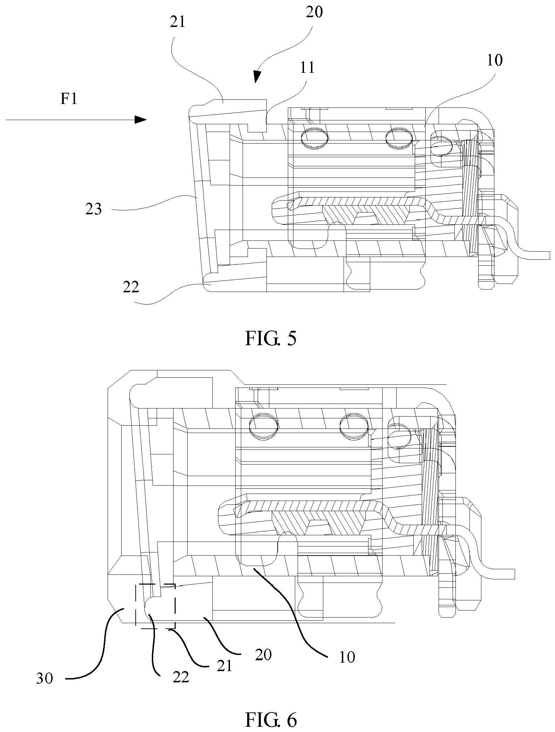

As shown in FIG. 3, FIG. 4, and FIG. 5, FIG. 3 and FIG. 4 show schematic structural diagrams of mobile terminal ports in two different shapes according to embodiments of the present invention, and FIG. 5 shows a sectional view of another mobile terminal port.

An embodiment of the present invention provides a mobile terminal port. The terminal port includes a port body 1 and a sealing cover 20. The sealing cover 20 is assembled surrounding an opening end of the port body 1. The sealing cover 20 has an elastic extrusion part 21 that extends outside the opening end. The elastic extrusion part 21 may be extruded and deformed along a vertical direction of the port body 1.

In the foregoing embodiment, the sealing cover 20 is directly assembled surrounding the port body 1. The sealing cover 20 extends outside an end face of the port body 1 in a parallel manner, and may form waterproof sealing with a housing of a waterproof mobile terminal device. However, an existing sealing silicone ring extends in a normal direction of a metal sleeve, and the housing 30 needs to be made to match a shape of the sleeve and then can be sealed. In comparison with the prior art, a parallel design is used in a sealing structure provided in this embodiment of the present invention, and the housing 30 can be assembled and sealed by using only a small plane. This greatly reduces a length of the mobile device and reduces an assembling difficulty. In addition, a vertical extrusion manner effectively improves a sealing effect.

For ease of understanding a structure and a principle of the mobile terminal port provided in this embodiment of the present invention, the following describes in detail the structure and the principle with reference to specific accompanying drawings and embodiments.

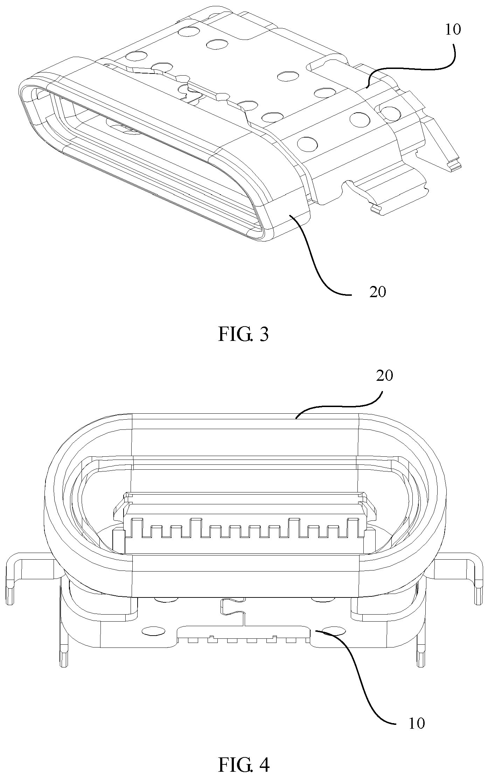

Still as shown in FIG. 3 and FIG. 4, the mobile terminal port provided in the embodiments includes a port body 1 and a sealing cover 20 that is assembled surrounding the port body 1. During specific disposal, the sealing cover 20 is assembled surrounding an opening end of the port body 1, and the sealing cover 20 has an elastic extrusion part 21 that extends outside the opening end of the port body 1. When the port body 1 is assembled inside a housing 30 of a mobile terminal, as shown in FIG. 6, the elastic extrusion part 21 touches the housing 30 and is extruded by the housing 30 for vertical deformation, so as to form sealing at a joint between the port and the housing 30. It can be seen from FIG. 6 that the housing 30 can be assembled and sealed by using only a small plane. This greatly reduces a length of a mobile device and reduces an assembling difficulty. In addition, in this sealing structure, when vertical extrusion is performed, sealing only needs to be performed on the sealing cover 20 of the mobile terminal port and at an opening location, reserved for the port body 1, on the housing 30. This decreases a quantity of components touched by the sealing cover 20 in a process of sealing, reduces a sealing failure caused by an assembly error, and further improves a sealing effect of the mobile terminal port.

When the port body 1 and the sealing cover 20 are specifically connected, different connection manners may be used. The sealing cover 20 and the port body 1 may be bonded by sealant. Alternatively, the sealing cover 20 may be directly injected and molded on the port body 1. Preferably, to ensure a sealing effect between the port body 1 and the sealing cover 20, the sealing cover 20 is injected and molded on the port body 1. The sealing cover 20 is directly injected and molded on the port body 1. This ensures sealing between the sealing cover 20 and the port body 1, and improves the sealing effect of the port. In a specific molding process, the sealing cover 20 is a silicone cover. That is, silicone is directly injected and molded around the port. In addition, injection and molding improve connection strength between the silicone cover and the port body 1. It can be seen from FIG. 5 that, when a force, for example, a horizontal force F1, is applied to the sealing cover 20, the sealing cover 20 has a sliding trend relative to the port body 1. A direct injection and molding manner can ensure that the silicone cover touches the port body 1 well, ensure that the silicone cover is in place, ensure that the elastic extrusion part 21, which extends outside the port body 1, of the silicone cover can be deformed effectively, and further ensure the sealing effect of the mobile terminal port.

Still as shown in FIG. 5, to further improve the sealing effect of the mobile terminal port provided in this embodiment, and improve the connection strength between the sealing cover 20 and the port body 1, a card slot 11 is disposed around a side wall of the port body 1, and the sealing cover 20 is clamped in the card slot 11. It can be seen from a structure in FIG. 5 that a protrusion part extending inside the card slot 11 is disposed on the sealing cover 20. The protrusion part increases a touching area between the sealing cover 20 and the port body 1. When a structure in which the card slot 11 matches the protrusion part is used, the matching between the card slot 11 and the protrusion part may provide a support force to the sealing cover 20, to prevent the sealing cover 20 from sliding vertically, and to ensure that the elastic extrusion part 21 of the sealing cover 20 can be deformed effectively.

In this embodiment, the elastic extrusion part 21 of the sealing cover 20 is configured to match the housing 30 to form a sealing structure. During specific disposal, the elastic extrusion part 21 may match a shape of the housing 30. For example, in a specific embodiment, an end face, which is far away from the opening end, of the elastic extrusion part 21 is an inclined surface 23 matching the housing 30 of the mobile terminal (as shown in FIG. 5). The elastic extrusion part 21 matches the housing 30 by using the disposed inclined surface 23, to ensure that the elastic extrusion part 21 can be deformed effectively when being assembled onto the housing 30, so as to form sealing with the housing 30. This avoids occurrence of a sealing failure caused due to an insufficient amount of elastic deformation, and ensures the sealing effect of the port.

As shown in FIG. 5 and FIG. 6, preferably, to further improve the sealing effect, a ring-shaped protrusion structure 22 is disposed on the end face, which is far away from the opening end, of the elastic extrusion part 21. The protrusion structure 22 is disposed on the end face of the elastic extrusion part 21, and a groove matching the protrusion structure 22 is correspondingly disposed on the housing 30. This increases a touching area between the housing 30 and the elastic extrusion part 21. In addition, in a process of sealing, deformation that can be performed on the elastic extrusion part 21 includes deformation of the protrusion structure 22 and overall deformation of the elastic extrusion part 21, and a cross-sectional area of the protrusion structure 22 is less than a cross-sectional area of the elastic extrusion part 21. Therefore, the protrusion structure 22 is deformed more easily, and sealing can be formed between the protrusion structure 22 and the groove. When the foregoing structure is used, sealing between the protrusion structure 22 and the groove and sealing between the housing 30 and a part other than the protrusion structure 22 on the end face of the elastic extrusion part 21 are performed, to implement sealing between the port and the housing 30. Therefore, the sealing effect can be effectively improved.

As shown in FIG. 6, an embodiment of the present invention further provides a mobile terminal. The mobile terminal includes a housing 30 and the foregoing mobile terminal port.

An opening structure is disposed on the housing 30. The mobile terminal port is located inside the housing 30, and an elastic sealing cover 20 of the mobile terminal port is connected to the opening structure in a sealing manner.

In the foregoing embodiment, the sealing cover 20 is directly assembled surrounding a port body 1. The sealing cover 20 extends outside an end face of the port body 1 in a parallel manner, and may form waterproof sealing with the housing of the waterproof mobile terminal device. However, an existing sealing silicone ring extends in a normal direction of a metal sleeve, and the housing 30 needs to be made to match a shape of the sleeve and then can be sealed. In comparison with the prior art, a parallel design is used in a sealing structure provided in this embodiment of the present invention, and the housing 30 can be assembled and sealed by using only a small plane. This greatly reduces a length of the mobile device and reduces an assembling difficulty. In addition, a vertical extrusion manner effectively improves a sealing effect.

As shown in FIG. 5 and FIG. 6, during specific disposal, when a ring-shaped protrusion structure 22 is disposed on an end face, which is far away from an opening end, of an elastic extrusion part 21, a groove matching the protrusion structure 22 is disposed on a side wall inside the housing 30 and around the opening structure. The groove matches the protrusion structure 22. Therefore, assembly accuracy is further improved, and the sealing effect is improved.

In a process of sealing, deformation that can be performed on the elastic extrusion part 21 includes deformation of the protrusion structure 22 and overall deformation of the elastic extrusion part 21, and a cross-sectional area of the protrusion structure 22 is less than a cross-sectional area of the elastic extrusion part 21. Therefore, the protrusion structure 22 is deformed more easily, and sealing can be formed between the protrusion structure 22 and the groove. When the foregoing structure is used, sealing between the protrusion structure 22 and the groove and sealing between the housing 30 and a part other than the protrusion structure 22 on the end face of the elastic extrusion part 21 are performed, to implement sealing between the port and the housing 30. Therefore, the sealing effect can be effectively improved.

As shown in FIG. 6, in a specific embodiment, a cross section of the groove is arc-shaped, and the protrusion structure 22 has an arc-shaped end face matching the groove. Matching of the arc-shaped groove further improves the sealing effect. In addition, using an arc-shaped structure facilitates processing and assembly, reducing a possibility of a failure caused by an assembly error.

Obviously, a person skilled in the art can make various modifications and variations to the present invention without departing from the spirit and scope of the present invention. The present invention is intended to cover these modifications and variations provided that they fall within the scope of protection defined by the following claims and their equivalent technologies.

## Claims

1. A mobile terminal port, comprising a port body and a sealing cover, wherein the sealing cover is assembled surrounding an opening end of the port body, the sealing cover has an elastic extrusion part that extends outside the opening end, and the elastic extrusion part is able to be extruded and deformed along a vertical direction of the port body.

2. The mobile terminal port according to claim 1, wherein a card slot is disposed around a side wall of the port body, and the sealing cover is clamped in the card slot.

3. The mobile terminal port according to claim 1 or 2, wherein an end face, which is far away from the opening end, of the elastic extrusion part is an inclined surface matching a housing of a mobile terminal.

4. The mobile terminal port according to claim 3, wherein a ring-shaped protrusion structure is disposed on the end face, which is far away from the opening end, of the elastic extrusion part.

5. The mobile terminal port according to any one of claims 1 to 4, wherein the sealing cover is injected and molded on the port body.

6. A mobile terminal, comprising a housing and the mobile terminal port according to any one of claims 1 to 5, wherein
an opening structure is disposed on the housing, the mobile terminal port is located inside the housing, and an elastic sealing cover of the mobile terminal port is connected to the opening structure in a sealing manner.

7. The mobile terminal according to claim 6, wherein when a ring-shaped protrusion structure is disposed on an end face, which is far away from the opening end, of the elastic extrusion part, a groove matching the protrusion structure is disposed on a side wall inside the housing and around the opening structure.

8. The mobile terminal according to claim 7, wherein a cross section of the groove is arc-shaped, and the protrusion structure has an arc-shaped end face matching the groove.
